# EUROPÄISCHE PATENTANMELDUNG

(11) **EP 2 012 132 A1**
(43) Veröffentlichungstag der Anmeldung: **07.01.2009**
(21) Anmeldenummer: 08159841.9
(22) Anmeldetag: 07.07.2008
(51) Int. Cl.: G01R 19/25, G01R 21/133

(54) **Verbrauchs- und Zustandsmesser**

(30) Priorität: 06.07.2007 DE 202007009511 U
(71) Anmelder: Aizo AG, 35578 Wetzlar (DE)
(72) Erfinder: Beck, Winfried, 65191 Wiesbaden (DE)
(74) Vertreter: Englaender, Klaus

(57) **Zusammenfassung**

Die Erfindung betrifft einen Verbrauchs- und Zustandsmesser der eine Analysevorrichtung für Stromverbraucher aufweist, umfassend: mindestens einen an ein Hausstromnetz angeschlossenen Stromverbrauchcr, wobei der Stromverbraucher eine Einheit umfasst, die geeignet ist den Stromverbrauch und/oder Leistungsverbrauch genau dieses einen Verbrauchers zu identifizieren und als Information bereitzustellen, mindestens eine Empfangsstelle für diese, durch den Stromverhraucher bereitgestellten Informationen, wobei diese Empfangsstelle geeignet ist, bei Zuschalten und/oder Ausschalten eines jeden Einzelnen dieser Stromverbraucher Informationen aus einem jeden Einzelnen dieser Stromverbraucher getrennt aufzunehmen und/oder getrennt zu verarbeiten und/oder mit Hilfe vorgegebener Algorithmen zu verrechnen, um hierdurch zu ermöglichen den Energieverbrauch von an einem Hausstromnetz angeschlossenen Verbrauchern zu reduzieren.

## Beschreibung

Die Erfindung betrifft einen Verbrauchs- und Zustandsmesser der geeignet ist, bei einem jeden in einem Stromnetz angebrachten Verbraucher dessen Strom∼ bzw. Leistungsverbrauch zu messen und Informationen hierüber bereitzustellen.

Bekannt sind lokale elektrische Verbrauchsmesser, die zwischen elektrischem Verbraucher und Steckdose zwischengesteckt werden. Dieses Prinzip kann bei eigentlich jedem elektrischem Verbraucher angewandt werden, der an das Hausstromnetz angeschlossen ist. Derartigen Verbrauchsmessern fehlt jedoch die Möglichkeit, dass deren bereitgestellte Information zusammen an mindestens einer zentralen Stelle einsehbar und abrufbar und gegebenenfalls von dieser zentralen Stelle aus beurteilbar und beeinflussbar ist. Ein Nachteil derartiger Zwischenstecker ist somit, dass pro Zwischenstecker die Leistung nur eines einzigen Verbrauchers zweifelsfrei identifiziert werden kann. Darüber hinaus sind derartige (Zwischen-)Stecker aufgrund der benötigten Bauelemente mindestens so groß wie eine menschliche Handfläche und liegen preislich um die 20 Euro pro Stück. Werden außerdem Verbraucher nicht an eine Steckdose, sondern direkt an den Stromkreis angeschlossen, so ist ein Zwischenstecker überhaupt nicht einsetzbar.

Der Stand der Technik schlägt darüber hinaus vor, beispielsweise weiße Ware, welche an sich keine Leistungsinformationen über sich Preis gibt, mit Hilfe eines so genannten "Smart Adapters" an ein Netzwerk anzuschließen. Derartige Smart Adapter können auch Module zur Leistungsmessung umfassen. Diese Leistungsdaten werden dann beispielsweise mit Hilfe eines ebenfalls im Smart Adapter enthaltenen Modems (z.B. PLT-22 Echelon) über die Stromversorgungsleitung an eine Zentrale zu übermitteln. Wenn hierbei das bestehende Stromnetz zur Übertragung verwendet wird, ist die Übertragungsrate bei derartigen Lösungen auf die Frequenz des in der Stromleitung fließenden Wechselstroms von ca. 50Hz, was ca. 50Bit/Sec entspricht, begrenzt. Ein weiterer Nachteil dieser Lösung ist, dass derartige Smart Adapter nur in der Lage sind, den Verbrauch eines einzigen Verbrauchers zu identifizieren, da sie nur messen können, welche Leistung gerade in dieser Leitung, in der sich der Smart Adapter befindet, verbraucht wird. Ob diese Leistung von einem oder mehr als einem Verbraucher konsumiert wird kann der Smart Adapter ebenso wenig wissen, die er wissen kann, welcher Verbraucher diese Leistung konsumiert. Ein weiterer Nachteil ist, dass ein in eine Stromleitung eingebauter Smart Adapter und seine Bauteile permanent in Betrieb sind und dabei eine permanente Leistung von ca. 5 Watt verbrauchen.

Diese Nachteile bestehen auch dann weiter, wenn derartige "Smart Adapter" in eine UP-Dose integriert werden. Auch in diesem Fall verbrauchen derartige Smart Adapter weiterhin ca. 5 Watt und sind nur in der Lage den Verbrauch von einem einzigen Gerät, z.B., zu identifizieren. Derartige "Smart Adapter" geben daher immer die Information aus: "*an mir ist mindestens ein Verbraucher angeschlossen, der xy Watt verbraucht*"; mehr nicht

Darüber hinaus schlägt der Stand der Technik Lösungen vor, an Knotenstellen der Stromversorgung in einem Haus den aktuellen Stromverbrauch aufzunehmen. Da an derartigen Knotenstellen üblicherweise mehr als ein Verbraucher angeschlossen ist, ist es auch diesen Lösungen nicht möglich den individuellen Verbrauch eines jeden Verbrauchers zu ermitteln.

Es ist daher Aufgabe der vorliegenden Erfindung eine Lösung bereitzustellen, wie der Energieverbrauch eines jeden an einen Stromkreis angeschlossenen Verbrauchers auch dann ermittelt werden kann, wenn an jedem Stromkreis mehr als ein Verbraucher angeschlossen sind.

Gelöst wird diese Aufgabe durch die Merkmale des unabhängigen Anspruchs. Weitere Ausgestaltungsformen ergeben sich aus den Unteransprüchen.

Eine Analysevorrichtung für Stromverbraucher umfassend: mindestens einen an ein Hausstromnetz angeschlossenen Stromverbraucher, wobei der Stromverbraucher eine Einheit umfasst, die geeignet ist den Stromverbrauch und/oder Leistungsverbrauch genau dieses einen Verbrauchers zu identifizieren und als Information bereitzustellen, mindestens eine Empfangsstelle für diese, durch diese Einheit bereitgestellten Informationen, wobei diese Empfangsstelle geeignet ist, bei Zuschalten und/oder Ausschalten eines jeden Einzelnen dieser Stromverbraucher Informationen aus einem jeden Einzelnen dieser Stromverbraucher getrennt aufzunehmen und/oder getrennt zu verarbeiten und/oder mit Hilfe vorgegebener Algorithmen zu verrechnen, bewirkt, daß sowohl die individuellen Werte des Energieverbrauchs eines jeden an ein Stromnetz angeschlossenen Verbrauchers, als auch die Alterung bzw. Verschleißzustand eines jeden dieser Verbraucher individuell identifizierbar sind. Dies kann auch geschehen, wenn eine jede Empfangsstelle Informationen von mehr als einer Einheit zugleich verarbeiten kann.

Diese individuelle Identifizierbarkeit ist auf vielfältigen Wegen erreichbar.

Einer dieser Wege sind die Anhaltspunkte die das Verbrauchsverhalten eines Verbrauchers liefert und welches Rückschlüsse auf seine Identität zuläßt. Diese Rückschlüsse sind technisch möglich, weil ein jeder elektrische Verbraucher ein seiner Gattung (Glühbirnen, Backöfen, Staubsauger, Fernseher etc.) typisches Verbrauchsverhalten und weil innerhalb seiner Gattung darüber hinaus auch jeder Typ (beispielsweise bei Glühbirnen der Typ der Leuchtstoffröhren, der Typ der Energiesparlampen, der Typ der Glühbirnen mit Wolframfäden) ein typisches Verbrauclisverhalten und weil innerhalb eines jeden dieser Typen auch das Produkt eines jeden Herstellers ein anderes typisches Verbrauchsvelhalten aufweist und weil darüber hinaus auch noch selbst ein jeder individueller Verbraucher im Laufe seines Lebens durch die Alterung seiner Bauelemente in einem gewissen Maß sein Verbrauchsverhaltens ändert. Auf diese erste Weise ist ein jeder Verbraucher so zusagen durch seinen elektrischen "Fingerabdruck" individuell identifizierbar, indem diese Verbraucher individuell mit Hilfe ihres individuellen Verbrauchsverhaltens identifiziert werden.

So aufweisen induktiven und kapazitiven Verbrauchsmuster eines jeden Verbrauchers, im übertragenen Sinn die Eigenschaft eines Fingerabdrucks auf. Dieser "elektrische Fingerabdruck" besteht aus einem Einschaltstromstoß und durch ihm in Hausstromnetz eingeprägten Oberwellen. Werden diese analysiert kann durch deren eigentümliche Zusammensetzung auf den verursachenden Verbraucher rückgeschlossen werden. Durch eine Identifikation des Charakters dieses individuellen Verbrauchsverhaltens des jeweiligen Verbrauchers ist so einerseits dessen Identifizierung möglich und andererseits ist es so möglich, wenn man diesen individuellen Verbrauchswert mit einem hinterlegten Normwert oder mit einem tolerierten Normwertebereich vergleicht, Aussagen über einen jeden individuellen Verbraucher zu tätigen. Dieser Vergleich von Normwerten mit individuellen IstWerten kann entweder an einer einzigen Stelle, also eine Zentrale, oder auch vor Ort, im oder direkt am Verbraucher selbst erfolgen. In letzterem Fall ist es notwendig, in oder an jedem Verbraucher eine Datenbank bereitzuhalten, welche den geschilderten Vergleich ermöglicht, indem sie Normwerte bereithält. Unabhängig von der Frage, ob nun die Informationen mim lokal in oder an jedem Verbraucher ausgewertet werden, oder ob diese Informationen an einer zentralen Stelle oder auch an mehreren zentralen Stellen ausgewertet werden, müssen mindestens diese Auswerteinformationen in jedem Fall an eine dritte Stelle übermittelt werden, an der die ausgewerteten Informationen für den Bediener lesbar angezeigt werden. Die Lösung diese Informationen direkt im- oder am Verbraucher auszuwerten bietet den Vorteil, dass nur die Auswerteergebnisse selbst zur Anzeige zu übermitteln sind, und nicht die störanfälligeren Verbrauchswerte. Im anderen Fall müssten erstens die am oder im Verbraucher aufgenommenen Verbrauchsmuster zu Auswertestelle übermittelt werden, dort verarbeitet werden und dann zu Ausgabestelle weitergeleitet werden. Dies hat den Nachteil, dass die störanfälligen Verbrauchsmuster während ihres Transports gestört werden können und damit die Qualität ihres Informationsgehalts sinkt. Anderseits hat dies den Vorteil, dass die Informationsmenge geringer ist und damit die vorhandene Bandbreite die zu übertragenden informationen nicht künstlich begrenzt. Ein weiterer Vorteil liegt im Preis, da eine Auswerteeinheit für viele Informationsquelle günstiger zu realisieren ist, als wenn für jede Informationsquelle eine eigene Auswerteeinheit bereitgehalten werden muß.

Der Wortlaut des Merkmals aus Anspruchs eins, dass der Stromverbraucher eine Einheit umfasst, die geeignet ist den Stromverbrauch und/oder Leistungsverbrauch genau dieses einen Verbrauchers zu identifizieren und als Information bereitzustellen, deckt somit auch die Möglichkeit ab, dass die sich im bzw. am Verbraucher befindliche Einheit z.B. auf Anforderung nur eine Statusinformation auszugeben in der Lage ist, wie z.B. einen individuellen Gerätecode.

In dieser zweiten Auslegung des Anspruchs eins kommt der mindestens einen Empfangsstelle für diesen, durch mindestens einen Stromverbraucher bereitgestellten Gerätecode die Aufgabe zu, diesen Gerätecode einerseits von der Einheit anzufordern und anderseits diesen von der Einheit angeforderten Gerätecode zu empfangen. Wenn nun die Empfangsstelle selbst, beispielsweise durch eigene Messung die Information vorliegen hat, welche Leistung verbraucht wird, so ergeben dieser Leistungswert und der Gerätecode zusammen die detaillierte Information: "*das durch den Code z identifizierte Gerät xy verbraucht die Leistungsmenge z*".

Auch im Fall, dass mehrere Geräte sequentiell eingeschalten werden, erkennt die Empfangsstelle dies und kalkuliert entsprechend sinngemäß: "*das durch den Code z1 identifizierte zum Zeitpunkt 1 zugeschaltene Gerät xy1 verbraucht die Leistungsmenge z1; das durch den Code z2 identfizierte zum Zeitpunkt 2 zugeschaltene Gerät xy2 verbraucht die Leistungsmenge z2; das durch den Code z3 identifizierte zum Zeitpunkt 3 zugeschaltene Gerät xy3 verbraucht die Leistungsmenge z3* ", wobei hierdurch bei gegebener Gesamtleistung die individuellen Leistungsmengen eines jeden Verbrauchers z.B. mit Hilfe von Algorithmen identifizierbar sind.

Auch im Fall, dass aus welchen Gründen auch immer die Empfangsstelle nur den Wert einer Gesamtleistung von z.B. 1100 Watt vorliegen hat, kann die Empfangsstelle die jeweiligen Einzelverbräuche eines jeden der angeschlossenen Verbraucher identifizieren, indem die Empfangsstelle die jeweiligen Gerätecodes anfordert und empfängt und in der Datenbank ermittelt, welchen typischen Verbrauch das Gerät xy1, xy2, xy3 aufweist und diese individuellen Leistungsdaten aus der Datenbank mit dem tatsächlichen Gesamtverbrauch so lange z.B. mit Hilfe von Algorithmen per Iteration abgleicht, bis realitätsnaher Wert ermittelt wurde.

Alternativ ist auch denkbar, dass bei gegebener Gesamtleistung ein Verbraucher für einen minimalen - den Betrieb unmerklichen - Augenblick ausgeschalten wird und mit Hilfe des hierbei entstehenden Leistungsabfalls der Anteil dieses Verbrauchers an der Gesamtleistung ermittelt wird. Auf diese Weise kann die Empfangsstelle einen realitätsnahen Wert für den Leistungsverbauch eines jeden Verbrauchers ermitteln. Hierfür muß die Analysevorrichtung lediglich geeignet sein, einen jeden Verbraucher kurzzeitig aus- und wieder anzuschalten, beispielsweise für wenige Millisekunden.

Ein grundlegendes Konzept der erfindungsgemäßen Analysevorrichtung ist damit, dass die Einheit des Stromverbrauchers unterschiedlich komplex und damit unterschiedlich teuer sein kann. Preiswerte Lösungen umfassen eine Einheit, welche beispielsweise einen Gerätecode umfassen. In diesem Fall erledigt die Empfangsstelle einen Großteil der zur Ermittlung geräteindividueller Leistungswerte notwendigen Arbeitsleistung. Da pro Stromkreis jedoch nur eine einzige Empfangsstelle notwendig ist, an die eine Vielzahl von Verbrauchern anschließbar sind, von welchen ein jeder Verbraucher eine erfindungsgemäße Einheit umfasst, ist eine derartige Lösung preiswert und insbesondere dann attraktiv, wenn ein extrem preisbewusste Hersteller sein Produkt nicht verteuern will, was erfindungsgemäß dadurch möglich ist, dass die vom Hersteller einzubauende erfindungsgemäße Einheit nur einen minimal notwendigen Funktionsumfang umfasst und die Empfangsstelle als Zusatzgerät, in welcher dann die notwendige Rechenarbeit geleistet wird, vom Endkunden selbst gekauft werden muß. Die Empfangsstelle wirkt damit als eine zentrale Recheneinheit, die alles das ergänzt, was die in den Verbrauchern befindlichen Einheiten selbst nicht können.

Erfindungsgemäße hochwertige Geräte umfassen hingegen Einheiten, in welchen neben Leistungsdaten auch Zusatzinformationen verarbeitet werden können, die den Betrieb des Verbrauchers auch komfortabler und/oder sicherer machen können. So könnte die erfindungsgemäße Einheit eines hochwertigen Herds bzw. Ofens neben den Leistungsdaten auch Betriebsdaten, wie z.B. Betriebstemperaturen bereitstellen, die dann genutzt werden können, dem Bediener Vorschläge zum energieoptimierten Umgang geben können.

Auf diese geschilderten vielfältigen Weisen ist die Empfangsstelle erfindungsgemäß geeignet, bei Zuschalten und/oder Ausschalten eines jeden Einzelnen dieser Stromverbraucher Informationen aus einem jeden Einzelnen dieser Stromverbraucher getrennt aufzunehmen und/oder getrennt zu verarbeiten und/oder mit Hilfe vorgegebener Algorithmen zu verrechnen.

Im Gegensatz zum Stand der Technik, in welchem die Antwort eines "Smart Meters" immer lautet: "*an mir ist mindestens ein Verbraucher angeschlossen, der xy Watt verbraucht*", die durch den Zusatz ergänzbar ist *"... aber ich weiß weder wie viele Verbraucher angeschlossen sind, noch welche, noch kann ich ermitteln, welche Leistung ein jeder dieser einzelnen Verbraucher benötigt*" lautet die Antwort der erfindungsgcmäßen Analysevorrichtung nun beispielsweise "*...an mir ist sowohl ein Toaster, als auch ein Fernseher angeschlossen, wobei der Toaster x Watt verbraucht und der Fernseher y Watt*".

Ein großer Vorteil der erfindungsgemäßen Lösung ist somit, dass durch diese Identifizierbarkeit, entweder per Code oder durch das Verbrauchsverhalten eines Verbrauchers ein jeder Verbraucher wiedererkennbar ist, wodurch z.B. der Toaster der Firma xy im Hausstromnetz erstens als Toaster und zweitens auch als dieser individuelle Toaster der Firma xy wiedererkannt wird, was auch dann gilt, wenn er von seiner angestammten Steckdose z.B. in der Küche entfernt wird und an eine ganz andere Steckdose z.B. im Arbeitszimmer an das Hausstromnetz angeschlossen wird.

So ist es auf die erfindungsgemäße Weise nun möglich, den Leistungsverbrauch eines jeden an ein Hausstromnetz angeschlossenen Verbrauchers auch dann weiterzuverfolgen und aufzusummieren, wenn dieser individuelle Verbraucher, wie z.B. ein Elektroheizgerät im Frühjahr aus seiner Steckdose im Wohnzimmer entfernt wird und im darauffolgenden Herbst an eine völlig andere Steckdose, z.B. im Schlafzimmer erneut angeschlossen wird. Hierdurch ist es möglich Ausgaben und damit Abrechnungen geräteindividuell aufzuschlüsseln, wodurch sie beispielsweise in einer Wohngemeinschaft selbst dann die Gestalt annehmen können "*Toaster der Person 1: Jahresverbrauch z Watt; Stereoanlage der Person 2: Jahresverbrauch y Watt*", wenn diese Geräte über das Jahr hinweg an unterschiedlichste Steckdosen des Hausstromnetzes angeschlossen waren.

Ein weiterer Vorteil der vorgelegten Erfindung ist es somit, den Energieverbrauch eines jeden an einen Stromkreis angeschlossenen Verbrauchers auch dann ermitteln zu können, wenn an jedem Stromkreis bzw, an jede Steckdose mehr als ein Verbraucher angeschlossen sind.

Vor dem Hintergrund dieser beiden Konzepte ist es vorteilhaft, wenn eine Analysevorrichtung für Stromverbraucher in einem Hausstromnetz, in welchem Stromverbraucher angeschlossen sind, mindestens ein Stromverbraucher umfasst der eine Einheit umfasst, die geeignet ist den Stromverbrauch und/oder Leistungsverbrauch genau dieses einen Verbrauchers zu identifizieren und als Information bereitzustellen. Hierdurch ist es möglich, vorn Verbraucher direkt, diesen charakterisierende Verbrauchswerte abzugreifen. Als solche Werte kommen insbesondere seinen induktives und kapazitives Verhalten in Betracht, bzw. sein Stromverbrauch bzw. Leistungsverbrauch. Vorteil einer derartigen Gestaltung ist eine minimale Störanfülligkeit der für die weitere Analyse notwendigen Werte. Verbraucher, welche eine derartige Einheit aufweisen, werden in dieser Anmeldung als "intelligente (elektrische) Geräte", bzw. als dS-ready-Getäte bezeichnet.

Vor diesem Hintergrund ist es weiterhin vorteilhaft, wenn mindestens eine Empfangsstelle für diese, durch mindestens einen Stromverbraucher bereitgestellten Informationen, bereitgehalten wird, die an einer anderen Stelle, als am Verbraucher direkt angeordnet ist. Beispielsweise kann diese an einer zentralen Stelle im Hausstrommetz, wie z.B. in der Sicherung angebracht sein.

Die erfindungsgemäße Lösung wird besonders einfach umgesetzt, wenn an jedem Stromkreis eine Empfangsstelle angeschlossen ist. Werden Verbraucher beispielsweise in Hotels an unterschiedliche Stromkreise angeschlossen, kann vorgesehen werden, dass gewisse Empfangsstellen ihre Informationen untereinander austauschen. Dies kann auf die selbe Weise geschehen, wie Einheit und Empfangsstelle ihre Informationen austauschen, aber auch durch Funk, Busleitungen etc.

Vor diesem Hintergrund ist es außerdem vorteilhaft, wenn diese Empfangsstelle geeignet ist, mit dem Zuschalten und/oder Ausschalten eines jeden Einzelnen dieser Stromverbraucher Informationen aus einem jeden Einzelnen dieser Stromverbraucher getrennt aufzunehmen und/oder getrennt zu verarbeiten und/oder mit Hilfe vorgegebener Algorithmen zu errechnen. Dies bewirkt, dass an dieser zentralen Stelle im Hausstromnetz die operative Berechnung und Analyse der angelieferten Informationen ermöglicht wird. Diese Berechnungsergebnisse können dann zu einer Mensch-Maschine-Schnittstelle weitergeleitet werden, an der diese einerseits für den Bediener identifizierbar ausgegeben werden und andererseits der Bediener die Möglichkeit hat, ihn interessierender Rechenoperationen einzugeben. Interessierende Rechenoperationen können beispielsweise sein: die Anzeige des individuellen Stromverbrauch eines jeden Verbrauchers, oder die Anzeige des Stromverbrauchs einer örtlichen Einheit, wie beispielsweise eines Raums, oder die Anzeige bzw. ggf. Ermittlung des altersbedingten Mehrverbrauchs an Energie eines jeden Verbrauchers, und/oder einer örtlichen Einheit; beziehungsweise die jeweils zugehörigen Kosten. Möglich sind hierdurch auch Vergleichsrechnungen, die dem Verbraucher einen Hinweis gegeben, welche Stromkosten er hätte, wenn er zu einem anderen Anbieter wechseln würde. Selbst wenn diese Daten von einem Anbieter nicht freiwillig bereitgestellt würden, beziehungsweise automatisch eingespeist würden, so ist es immer möglich, dass der Bediener diese Daten individuell eingibt, und so dem erfindungsgemäßen Verbrauchs- und Zustandsmesser zur Weiterverarbeitung Verfügung stellt.

Eine vorteilhafte Ausgestaltungsform der Erfindung, bei welcher die Empfangsstelle erkennt, welcher Verbraucher an der Stromversorgung angeschlossen ist, bewirkt, dass die im Verbraucher befindliche Einheit weniger Rechenkapazität aufweisen muß und damit preiswerter produziert werden kann. Vielmehr kann in einem solchen Fall die durch die Einheit bereitzustellende Rechenkapazität auf ein Minimum reduziert werden. In einem solchen Fall übernimmt die Empfangstelle die Rechenarbeit, indem sie beispielsweise Informationen von mindestens einer Einheit empfängt, diese Informationen auswertet, in der Auswertung den Verbraucher identifiziert, und die Information, um welchen Verbraucher es sich handelt ausgibt. Alternativ oder zusätzlich können neben den Informationen, um welchen Verbraucher es sich handelt in der Empfangsstelle auch Eigenschaften dieses Verbrauchers ermittelt werden. Diese Ermittlung kann beispielsweise dadurch geschehen, indem nach der Identifikation des Verbrauchers mit Hilfe gängiger Iterationsmethoden Eigenschaften des Verbrauchers ermittelt werden. So kann beispielsweise die Empfangsstelle die von vielen an die Empfangsstelle angeschlossenen Verbrauchern verbrauchte Gesamtleistung ermitteln, was preiswerter ist, als wenn die im Verbraucher befindlichen Einheiten selbst die Einzelverbräuche ermitteln. Wenn nun auf erfindungsgemäße Weise bei bekanntem Gesamtverbrauch aller Verbraucher eine Einheit an die Empfangsstelle meldet: "*ich, der Toaster, bin im Betrieb*", so kann die Empfangsstelle aus einer Datenbank den für diesen Toaster typischen Leistungsverbrauch heraussuchen und vom Gesamtverbrauch abziehen, mit dem Ergebnis, dass nun die Empfangsstelle die Informationen beinhaltet, dass der Toaster x Watt und der Rest y Watt an Leistung verbraucht. Alternativ kann der augenblickliche Leistungsverbrauch auch durch ein kurzzeitiges Ausschalten des betreffenden Verbrauchers von wenigen Millisekunden ermittelt werden. Hierzu ist die Analysevorrichtung mit einer eigenständigen Kurzabschaltfunktion für Verbraucher ausgestattet.

Für den Fall, dass die Einheit und/oder die Empfangsstelle derart ausgestaltet sind, dass sie eine Meldung immer dann erhalten, wenn ein Verbraucher ein- bzw- ausgeschalten werden ist auch die Dauer des Leistungsverbrauchs ermittelbar. Alternativ kann natürlich auch permanent abgefragt werden, welche Verbraucher gerade in Betrieb sind. Sind die Informationen der Betriebszeit und welches Gerät in Betrieb ist, vorhanden, so kann unter Verwendung dieser Informationen eine gerätespezifische Einzelabrechnung erstellt werden.

Eine Datenbank mit verbrauchertypischen Verbrauchswerten kann entweder aufgebaut werden, indem gerätetypische Leistungswerte von außen eingegeben werden, oder indem sich diese Datenbank selbsttätig programmiert. Eine selbsttätige Programmierung kann dadurch geschehen, indem immer wenn ein neues unbekanntes Gerät an die Stromversorgung angeschlossen wird, dies von der Einheit und/oder der Empfangsstelle erkannt wird und ein neuer Eintrag in die Datenbank vorgenommen wird. Dieser Eintrag kann Informationen über die verbrauchte Leistung umfassen, oder auch typische Leistungsverläufe. Wird beispielsweise ein neuer Staubsauger, der eine variable Saugstärke umfasst erstmals angeschlossen, so könnte der automatische Eintrag in die Datenbank lauten *"neues unidentifiziertes Gerät mit einem Verbrauch von x bis y Watt"*. Dieser Eintrag könnte dadurch präzisiert und damit gefestigt werden dass das Gerät durch typische Verhaltensveisen, wie beispielsweise der Gestalt seines Einschaitstromstoßes oder typische Verbrauclisverläufe als ein bereits in der Datenbank eingetragenes Gerät widererkannt wird.

Eine Identifizierung des Geräts mit einer typischen Leistungskurve kann somit entweder durch einen manuellen Eintrag, durch das Liefern typischer Leistungskurven durch den Hersteller, oder aber auch durch Identifikation des Gerätes durch eine Geräte-ID erfolgen.

Indem die Empfangsstelle auf eine dieser Weise erkennt, welcher Verbraucher an der Stromversorgung angeschlossen ist kann vorteilhaft der Leistungsverbrauch eines jeden einzelnen Verbrauchers ermittelt werden.

Eine vorteilhafte Ausgestaltungsform der Erfindung, bei welcher die Empfangsstelle einen jeden Verbraucher wiedererkennt, wenn er von seiner bisherigen Stromversorgung abgekoppelt und an einer anderen Stelle erneut an die Stromversorgung angekoppelt wird, bewirkt, dass der Verbraucher an eine jede Streckdose im Gebäude angeschlossen werden kann, ohne dass die Information verloren geht, wie viel Leistung er bis zum Abkoppeln schon verbraucht hat. Wird der zuvor erwähnte Staubsauer beispielsweise von der Steckdose im Wohnzimmer abgekoppelt und an die Steckdose im Arbeitszimmer angekoppelt, so wird dieser selbe Straubsauer wiedererkannt.

Eine vorteilhafte Ausgestaltungsform der Erfindung, bei welcher beim Ein- und/oder auskoppeln ein jeder Verbraucher einem Verbrauchskonto zugeordnet wird, bewirkt, dass einem jedem Raum ein eigenes Konto zugewiesen werden kann. Wird beispielsweise der zuvor erwähnte Staubsauger im Arbeitszimmer angekoppelt, und hat das Arbeitszimmer ein eigenes Verbrauchskonto, so kann der zum Staubsaugen des Arbeitszimmers nötige Verbrauch diesem Arbeitszimmer zugewiesen werden. Da auch die Zeiten des An- und Abkoppelns definiert sind und da auch die Gesamtbetriebszeit des Staubsaugers definiert ist, kann Anteil ermittelt werden, zu welchem der Verbraucher (z.B. Staubsauger) im Arbeitszimmer im Einsatz war. Auf diese Weise kann eine präzise Abrechnung für einen jeden Raum erstellt werden, was in Hotels, vermieteten Konferenzräumen, Arbeitszimmern im Privatgebäude von großem Vorteil ist. Durch die ermittelbaren Betriebsanteile kann auch die anteilige Abschreibung des Geräts mit in die Rechnung einfließen.

Eine vorteilhafte Ausgestaltungsform der Erfindung, bei welcher die Einpfangsstelle erkennt, welches Gerät an der Stromversorgung angeschlossen ist, indem die Einheit geeignet ist den Stromverbrauch und/oder Leistungsverbrauch genau dieses betreffenden Verbrauchers zu identifizieren und als Information bereitzustellen, indem diese Einheit gerätetypische informationen bereitstellt, bewirkt, dass ein jedes Gerät wenn es einmal angeschlossen war, wiedererkannt werden kann. Diese Wiedererkennung kann auf vielfältigem Wege geschehen.

Eine vorteilhafte Weide der Widererkennung erfolgt, indem diese gerätetypischen Informationen die Gestalt einer Geräteidentifikationsziffer, und/oder die Gestalt eines gerätetypischen Schwingungs verhalten im Versorgungsstrom und/oder in der Versorgungsspannung, und/oder die Gestalt gerätetypischer Zusatzinformationen aufweisen. Hierbei kann die Geräteidentifikationsiffer, bzw. Ceräte-ID Zifferngruppen bzw. Codes enthalten, die den Hersteller und/oder den Gerätetyp und/oder das Baujahr und/oder die Gerätenummer, und/oder eine Leistungsgruppe und/oder eine Energieeffizienzgruppe etc. repräsentieren.

Die gerätetypischen Zustzinformationen für das Gerät können auch charakteristische Sensordaten, die beispielsweise Temperaturinformationen, Feuchtigkeitsinformationen, Füllstände, Helligkeitsinformationen, Lautstärkeinformationen, Steuerungsinformationene, Verlaufsinformationen eines durchgeführten Arbeitsprozesses, Informationen betreffend des Verbrauchs von Verbrauchsmaterialien etc. umfassen. Auf diese Weise kann ein jedes Gerät durch die Identifikation einer dieser Eigenarten beim Ankoppeln und/oder abkoppeln vom Stromkreis wiedererkannt werden. Prinzipiell ist es so möglich, Informationen, welche ein jeder Verbraucher bereitstellt, mit Hilfe einer zusätzlichen Leitung (Bussystem), oder per Funk beziehungsweise anderen drahtlosen Techniken zu übermitteln.

Eine vorteilhafte Weise der Widererkennung erfolgt, indem die gerätetypischen Informationen über die Stromleitung zu einer von der Einheit örtlich getrennten Empfangsstelle weitergeleitet werden, bewirkt, dass keine eigenen Leitungen gelegt werden müssen, wie es beispielsweise bei Bussystemen der Fall ist, bzw. bewirkt, dass das Gebäude nicht von Funkstrahlungen belastet wird, um Informationen von der Einheit zur Empfangsstelle zu übermitteln.

Eine vorteilhafte Weiterleitung erfolgt, beispielsweise indem die gerätetypischen Informationen innerhalb des Stromnetzes über die Energieversorgungsleitung zu einer von der Einheit örtlich getrennten Empfangsstelle weitergeleitet werden, insbesondere indem die gerätetypischen Informationen in der Energieversorgungsleitung mit Hilfe des elektrischen Stroms als Trägermedium zur Empfangsstelle weitergeleitet werden.

Eine Möglichkeit die Stromleitung als Übertragungsmedium zu verwenden ist die Verwendung einer der im Stand der Technik angebotenen "Power-Line"-Lösungen. Die auf dem Markt befindlichen Lösungen basieren entweder auf einer HF-Technologie, indem die zu übertragenden Informationen in HF-Signale umgewandelt werden, die wiederum dem Trägerstrom oder der Trägerspannung aufmoduliert werden. Diese Methode hat den Nachteil, dass hierdurch die gesamte elektrische Hausinstallation als Sendemast wirkt und die sich im Gebäude befindlichen Menschen dieser HF-Frequenz permanent ausgesetzt sind.

Eine andere Möglichkeit die Stromleitung als Übertragungsmedium zu nutzen ist, aus der 50-Hz-Frequenz des Trägermediums Teilwellen, wie z.B. eine Halbwelle herauszuschneiden und diese Manipulation als Informationsträger zu nutzen. Diese Möglichkeit hat jedoch den Nachteil, dass deren Bandbreite auf 50Hz begrenzt ist und dass dem angeschlossenen Verbraucher ein Teil der zum ordnungsgemäßen Betrieb notwendigen Leistung vorenthalten bleibt. So zeigt eine Glühlampe im Fall, dass nur einige wenige Halbwellen der 50-Hz-Schwingungen zu Informationszwecken durch Herausschneiden manipuliert werden ein deutliches Flackern in seiner Lichtwiedergabe. Anderseits hat diese Lösung den Vorteil, dass sie jedoch besonders störunanfällig und abhörsicher ist, was die Wiederauslesbarkeit von übermittelten Daten erhöht. Weiterhin ist sie vor Sabotage sicherer, da niemand gerne eine 220V oder 110V-Tromleitung durchtrennt. Hierbei dient das Hausleitungsnetz sozusagen als "Strombus", wobei vorteilhafterweise eine zusätzliche Busleitung unnötig ist.

Eine vorteilhafte Weise Stromleitung als Übertragungsmedium zu verwenden erfolgt, indem die Analysevorrichtung für Stromverbraucher eine Informationsübertragung mit Hilfe der Stromversorgungsleitung mit mehr als 50Hertz, i.e. mehr als 50 Bit/Sec erlaubt.

Eine noch vorteilhaftere Weise Stromleitung als Übertragungsmedium zu verwenden erfolgt, indem die Analysevorrichtung für Stromverbraucher eine Informationsübertragung mit Hilfe der Stromversorgungsleitung mit mehr als 1 00Hertz, i.e. mehr als 100 Bit/Sec erlaubt.

Sowohl eine Informationsübertragung von mehr als 50Hz, als auch eine Informationsübertragung von mehr als 100Hz ist durch die Verwendung der in der WO 05124477 geschilderten "digitalSTROM"-Konzepts, welches durch Bezugnahme Teil dieser Schutzschrift ist, erreichbar. Der hierin beschriebene Informationstransport mit Hilfe einer Wirkleistungsmodulation vermeidet sowohl die Nachteile einer HF-Lösung, als auch die Nachteile des Ansatzes Teilwellen aus einer Schwingung der Versorgungsspannung oder dem Versorgungsstrom herauszuschneiden und ist darüber hinaus auch noch besonders störunanfällig, was auch bedeutet, dass die einmal zur Übermittlung bereitgestellten Daten selbst bei externen Störungen, die während ihrer Übermittlung beispielsweise durch das zuschalten von zusätzlichem Kraftwerkkapazitäten oder durch das zuschalten eines neuen Verbrauchers im Stromnetzes gestört werden können, besonders störungssicher und damit lichter wieder auslesbar sind. Diese Codierungsweise von Informationen wird daher in dieser Anmeldung der WO 05124477 folgend mit Hilfe des Begriffs "digitalSTROM" bezeichnet.

Durch Verwendung des bestehenden Hausstromnetzes ist es mit Hilfe von "digitalSTROM" möglich, im Nachhinein, ohne Umbauten und unter Vermeidung von zusätzlichem Elektrosmog (der bei HF-Übertragungen anfällt), einen jeden Haushalt mit "intelligenten elektrischen Geräten" auszustatten.

Was bis dato unter der Bezeichnung "smart home" ein Luxusprodukt ist, wird auf die erfindungsgemäße Weise in jedem Haushalt möglich sein. Hierdurch ist es möglich, im gesamten Altbaubestand, auf preiswerte und unkomplizierter Weise Mit Hilfe von digitalSTROM die Vernetzung von Geräten im Gebäudebestand voranzutreiben und so Komfort und Funktion auch in Altbauten verbessern. Hierdurch ist es aber im Gebäudebestand auch möglich, da einer der Bedienerin eines solchen erfindungsgemäßen Netzes, die Möglichkeit hat, jeden Verbraucher individuell in seinem Verbrauchsverhalten zu erkennen, bzw. zu beobachten, dass dieser Maßnahmen ergreift, um seinen Energieverbrauch zu optimieren.

DigitalSTROM arbeitet nicht auf der Basis von Frequenzmodulation und hat dadurch eine hohe Funktionssicherheit und eine extrem kleine Bauform. Netzteil, Prozessor, Kommunikation sowie eine Vielzahl von direkten Anschlüssen für verschiedenste Aufgaben konnten auf einem einzigen Hochvoltchip (dS-Chip) integriert werden, der ohne zusätzliche Elektronik direkt auf die 230 oder 110 V Leitung angebracht wird.

Weitere Vorteile der digitalSTROM Technologie sind daher:
- minimale Einbaugröße
- günstiger Preis
- hohe Flexibilität
- hohe Zuverlässigkeit
- hohe Verträglichkeit mit existierenden Infrastrukturen und Systemen
- geringer und kontrollierter Stromverbrauch
- plug & play-Intelligenz ohne neue Kabel oder Umbauten
- mehr Komfort und Funktionen
- einfache, durchgängige Bedienung

DigitalSTROM ist daher geeigneter als bekannte Konzepte wie Lösungen mit Powerline oder Funk, um Informationen zu übertragen. Weitere Vorteile des DigitalSTROMs sind, daß die Energieversorgung zugleich eine komfortable Informationsversorgung bei hoher Sicherheit aufgrund Störunanfälligkeit bereithält, und daß es einfach mit Hilfe des Plug & Play-Prinzips beliebig erweiterbar ist.

Eine vorteilhafte Ausgestaltungsform der Erfindung, bei welcher der Beginn der Informationsübertragung ausschließlich durch einen Wirklistungsimpuls bereitgestellt wird bewirkt, dass der Beginn der Datenübertragung und das Ende der Datenübertragung eindeutig definiert sind.

Eine vorteilhafte Ausgestaltungsform der Erfindung, bei welcher Analysevorrichtung jeden individuellen und/oder berechneten Stromverbrauch auszugeben in der Lage ist bewirkt, dass entweder die durch die Einheit individuell und unmittelbar ermittelten Energieverbräuche an die Empfangseinheit weitergeleitet werden und durch diese ausgegeben werden, oder sie bewirkt, dass die durch die Empfangseinheit berechneten Energieverbräuche eines jeden Verbrauchers, beispielsweise nachdem die Einheit lediglich gerätetypische Informationen, wie z.B. die Geräteidentifikationsiffer, bzw. Geräte-ID an die Empfangseinheit weitergeleitet hat, durch diese ausgegeben werden. Egal auf welchem Wege also der Stromverbrauch eines jeden Verbrauchers ermittelt wird, unmittelbar in der Einheit, oder mittelbar durch die Übermittlung der Geräte-ID durch die Empfangsstation, in jedem Fall ist der Stromverbrauch bzw. Energieverbrauch eines jeden Verbrauchers ausgegeben. Auf diese Weise kann eine Rechnung vorteilhaft so gestaltet werden, dass sie jeden einzelnen Verbraucher auf der Rechnung aufführt und ihm seinen eigenen Verbrauch zuordnet und hierdurch die durch ihn verursachten Kosten zuordnet.

Aus diesem Grund werden die Kosten durch Zusammenwirken der Einheit und der Empfangseinheit letztendlich durch die gesamte Analysevorrichtung ermittelt.

Eine vorteilhafte Ausgestaltungsform der Erfindung, bei welcher die Analysevorrichtung jeden individuellen und/oder berechneten Stromverbrauch einer Gerätegruppe auszugeben in der Lage ist, bewirkt, dass Verbrauchsgruppen gebildet werden können, die von der Raumaufteilung unabhängig sind. So können beispielsweise Verbrauchsgruppen nach ihrer Energieeffizienzklasse gebildet werden, indem alle Geräte der Effizienzklasse der Gruppe A++ einer Gruppe zugeordnet werden, die der Gruppe A+ einer weiteren Gruppe etc. Derartige Gruppen können dann eigens kategorisiert bzw, angesteuert werden, indem man beim Wunsch Energie zu sparen, beispielsweise allen Geräten der Energiecffizienzklasse C bzw. C-und schlechter ein Energiekontingent zuordnet bei dessen Überschreiten ausschließlich den Geräten dieser Effizienzklasse die verfügbare Leistung reduziert wird. Als Wirkung der Reduktion, könnte beispielsweise die im Verbraucher befindliche Einheit bei der Waschmaschine den 90Grad-Waschgang sperren und nur noch 60Grad-Wäsche erlauben, oder 100-Watt Glühbirnen die Leistungszufuhr reduzieren etc.

Eine andere Gruppeneinteilung könnte hinsichtlich der Gerätetypen erfolgen, wie beispielsweise alle Heizungs- bzw. Klimageräte oder alle Leuchtmittel, oder alle sicherheitsrelevanten Stromverbraucher oder alle Verbraucher der Konsumelektronik oder alle Verbraucher welche in Steckdosen gesteckt werden können in einer Gruppe zusammenzufassen.

Eine vorteilhafte Ausgestaltungsform der Erfindung, bei welcher die Analysevorrichtung, und/oder die Einheit, die geeignet ist den Stromverbrauch und/oder Leistungsverbrauch genau dieses einen Verbrauchers zu identifizieren und als Information bereitzustellen, auch geeignet ist, genau diesen Stromverbraucher an- bzw. auszuschalten, bewirkt, dass im Falle von nur begrenzt vorhandener Energie Verbraucher die einer bestimmten Gruppe zugeordnet sind, bevorzugt mit Energie beliefert werden könnten, indem Verbraucher, die keiner dieser privilegierten Gruppen zugeordnet sind, entweder die Energiezufuhr reduziert, oder sogar ganz abgeschaltet wird und im Fall, dass wieder hinreichend Energie vorhanden ist, wieder angeschaltet wird.

So können beispielsweise im Falle einer Energieknappheit Wäschetrockner, die wesenhaft einer schlechten Gruppe zugehören und viel Energie verbrauchen abgeschalten oder in ihrem Leistungsverbrauch reduziert werden und wenn wieder viel Energie vorhanden ist, wieder zugeschalten werden. Dies kann auch aus der Ferne durch das Energieversorgungsunternehmen geschehen.

Eine vorteilhafte Ausgestaltungsform der Erfindung, bei welcher die Ausgabe von Daten mit Hilfe von Fernkommunikationsmitteln an einem Ort geschieht, der sich außerhalb des Gebäudes befindet, in welchem diese Daten aufgenommen wurden bewirkt, dass das Energieversorgungsunternehmen die zuvor genannten Abrechnungen zentral erstellen kann. So können in einem weiteren Schritt die in/für jedem/n Haushalt erfindungsgemäß aufbereitetem Energiedaten beziehungsweise Verbrauchsdaten auch an eine übergeordnete Organisation, wie beispielsweise an den Energieversorger weitergegeben werden. Hierdurch ist es möglich, dass der Energieversorger Daten für die Rechnungslegung eines jeden Kunden unmittelbar abgereift. Dies hat zur Folge, dass der Energieversorger so in die Lage versetzt wird, für jeden elektrischen Verbraucher individuelle Stromtarife anzubieten. Beispielsweise könnte für eher ökologisch bedenkliche Verbraucher, oder überflüssig erscheinende Verbraucher, wie beispielsweise veraltete Geräte oder defekte Geräte ein anderer, wohl höherer Stromtarif angeboten werden. Umgekehrt argumentiert könnten für notwendige aber auch für "politisch korrekt" erscheinende Geräte besonders günstige Tarife angeboten werden. In einem solchen Fall könnten also Gruppen mit sparsamen Geräten priorisiert mit Energie versorgt werden, oder es kann einer jeden Gruppe ein Budget zugewiesen werden, oder der Energieversorger bzw, die Politik kann gestaffelte Preise anbieten, beispielsweise geringe Preise für Geräte einer guten Energieffizienzgruppe und erhöhte Preise einer hohen Energieffizienzgruppe.

Wenn die erfindungsgemäße Analysevorrichtung für Stromverbraucher den aktuellen Energieverbrauch eines jeden dieser Stromverbrauchers berechnet, bzw, wenn die erfindungsgemäße Analysevorrichtung für Stromverbraucher jeden individuellen und/oder berechneten Stromverbrauch auszugeben in der Lage ist, bzw. wenn die erfindungsgemäße Analysevorrichtung für Stromverbraucher die Kosten ermittelt, welche dem aktuellen Energieverbrauch eines jeden dieser Stromverbrauchers entsprechen, so ist es hierdurch einerseits möglich, die Kosten eines jeden einzelnen Verbrauchers individuell über einen beliebigen Zeitraum zu ermitteln. Hierdurch kann ein jeder Bediener sein eigenes Verbraucherverhalten neu justieren. Weiterhin ist er in der Lage, die Angaben des Stromverbrauchs von Geräten durch die Produzenten der Geräte individuell zu kontrollieren. Der Bediener hat außerdem die Möglichkeit alte und defekt erscheinende Geräte frühzeitig zu erkennen und so zu ersetzen. Weiterhin ist es ihm möglich, wenn darüber hinaus die Funktion eingebaut ist, um die durch ein Gerät unnötigerweise verursachten Zusatzkosten (beispielsweise durch einen Vergleich von Normkosten mit aktuellen Ist-Kosten) zu ermöglichen, der Bediener ersehen kann, wann es für ihn wirtschaftlich ist, sich ein neues Gerät anzuschaffen, indem er die durch Mehrverbrauch verursachten Kosten ermitteln kann, um auf deren Basis abschätzen oder errechnen zu können, ab wann sich ein Neukauf, der weniger Strom verbraucht, amortisiert.

Andererseits ist es dem Energieversorgungsunternehmen hierdurch möglich, völlig neue Tarife einzuführen. So können beispielsweise Verbraucher, welche einen geringen Energieverbrauch aufweisen, oder Verbraucher, welche keine Abweichungen von ihrem Normverbrauch aufweisen, Strom zu einem ihnen eigenen (besonders günstigen) Tarif beziehen, während andere Verbraucher ihren Strom zu einem höheren Tarif beziehen müssen. Hierdurch ist es möglich, Kunden mit besonders niedrigem Energieverbrauch zu belohnen. In einem weiteren Schritt ist es hierdurch auch möglich, dass Energieversorger, beispielsweise nach einem Zusammenbruch eines Netzes beim Wiederhochfahren dieses Netzes, aus der Ferne zuerst privilegierte Verbraucher wieder mit Strom versorgen, um so sicherzustellen, dass in jedem Haushalt eine Grundversorgung (beispielsweise für Tiefkühltruhen oder Alarmanlagen oder generell Verbraucher einer besonders niedrigen Energieverbrauchsklasse, wie z.B. A++) sichergestellt werden kann, während weniger notwendige Geräte, oder besonders hohe Stromverbraucher zu einem späteren Zeitpunkt wieder mit Strom versorgt werden. Alternativ ist es aber auch möglich einen Netzzusammenbruch dadurch zu verhindern, daß zuerst nicht privilegierte Verbraucher abgeschaltet werden, um so Last vom Netz zu nehmen. Diese Funktion ist insbesondere für Länder interessant, in welchen kein stabiles Stromnetz zur Verfügung steht, oder in Ländern in welchen Stromkonzerne mit hohen Strafzahlungen im Falle eines Netzausfalls konfrontiert sind.

Eine vorteilhafte Ausgestaltungsform der Erfindung, bei welcher die Analysevorrichtung Zugriff auf Informationen hat, die als Maßstab für den Verschleißzustand eines jeden Verbrauchers dienen, bewirkt, dass neben dem Energieverbrauch der Analysevorrichtung auch eine weitere Information, nämlich des Verschleißes zur Verfügung steht. Vergleicht man diese Informationen mit Informationen die den Zustand ohne Verschleiß repräsentieren, so kann auch diesen beiden Daten für jedes der Geräte der aktuelle Verschleißstatus ermittelt werden. Da bei zunehmendem Verschließ erfahrungsgemäß der durch den Verbraucher benötigte Energiebedarf steigt, ist der Verschleißzustand einer der zuvor erwähnten gerätetypischen Zusatzinformationen.

Da ein extremer Verschleiß zu einem Defekt führt, bzw, einen bereits bestehenden Defekt anzeigen kann, kann auf die erfindungsgemäße Weise zusätzlich ein Anzeigeorgan angesteuert werden, welches die Zusatzinformation ausgibt, ein zu stark verschlissenes Gerät sei auszutauschen, bzw, um ein defektes Gerät anzuzeigen.

Wenn die erfindungsgemäße Analysevorrichtung für Stromverbraucher Zugriff auf Informationen hat, die als Maßstab für den Verschleißzustand eines jeden Verbrauchers dienen, so ist es hierdurch möglich, mit dem Verschleißzustand auch die Reparaturanfälligkeit eines jeden Verbrauchers zu ermitteln. Hierdurch wird der Bediener in die Lage versetzt, für jeden einzelnen Verbraucher eine individuelle Wirtschaftlichkeitsabschätzung vorzunehmen. Dies kann hierdurch geschehen, indem die erfindungsgemäße Analysevorrichtung für Stromverbraucher die Informationen, die als Maßstab für den Verschleißzustand eines jeden Verbrauchers dienen, mit jenen Informationen vergleicht, die dieser Verbraucher aktuell bereitstellt und hieraus dessen Verschleißzustand ermittelt.

Die erfindungsgemäße Analysevorrichtung für Stromverbraucher, wobei die Einheit, die geeignet ist den Stromverbrauch und/oder Leistungsverbrauch genau dieses einen Verbrauchers zu identifizieren und als Information bereitzustellen, auch geeignet ist, genau diesen Stromverbraucher individuell an- bzw. auszuschalten, weist den Vorteil auf, dass hierdurch der Ein- Aussehaltknopf eines jeden stromverbrauchenden Geräts umgangen werden kann, da der Stromfluß eines jeden individuell angeschlossenen Stromverbrauchers auf die erfindungsgemäße Weise vor dem Stromverbraucher unterbrochen werden kann. Hierdurch kann der Stromverbrauch dieses betreffenden Stromverbrauchers signifikant reduziert werden, da eben die erfindungsgemäße Schaltung vor dem Netzteil des Verbrauchers angesiedelt ist.

Wenn die erfindungsgemäße Analysevorrichtung für Stromverbraucher den Beginn der Informationsübertragung ausschließlich durch einen Wirkleistungsimpuls bereitgestellt, so ist es aufgrund der Störungsresistenz eines Wirkleistungsimpuls möglich, ein im Prinzip nicht störbares und in jedem Fall wieder auslesbares Startsignal und auch, falls von Interesse, ein derartiges Endsignal bereitzustellen, um so eigene Sequenz zu definieren, innerhalb derer Informationsübertragung stattfindet.

Wenn die erfindungsgemäße Analysevorrichtung für Stromverbraucher, eine Ausgabe von Daten mit Hilfe von Fernkommunikationsmitteln an einem Ort erlaubt, der sich außerhalb des Gebäudes befindet, in welchem diese Daten aufgenommen wurden, so ist es möglich, dass diese Daten auch von Dritten, wie beispielsweise Energieversorgern, genutzt werden. Hierdurch wird der Energieversorger in die Lage versetzt, auf Basis dieser Daten individualisierte, also für jeden Haushalt, oder jede Straße, oder jeden Verwaltungsbezirk etc. individualisierte Kapazitätsplanungen zu betreiben, so wie auch für diese individualisierte Tarifmodelle zu gestalten. In diese können dann Faktoren einfließen, wie beispielsweise Geräteausstattung des Kunden, Nähe des Kunden zu einem Kraftwerk, Prognostizierbarkeit des Kundenverhaltens etc.

Eine vorteilhafte Ausgestaltungsform der Erfindung, bei welcher die Analysevorrichtung elektronische Bauelemente umfasst, die insgesamt weniger als 5 Watt, insbesondere weniger als 3 Watt, insbesondere weniger als 1 Watt, insbesondere weniger als 0,3 Watt und insbesondere weniger als 0,1 Watt Leistung verbrauchen bewirkt, dass die Analysevorrichtung permanent in Betrieb bleiben kann und hierbei durch die zuvor geschilderten Funktionen mehr Energie einzusparen in der Lage ist, als sie selbst verbraucht. Gegenwärtig erhältliche Lösungen der Energiemessung verbrauchen durch die für die Energiemessung notwendigen Bauelemente, sowie für die Bauelemente, welche zur Übermittlung dieser Daten per Funk, Bus oder Powerline notwendig sind, mehr Energie als sie in der Lage sind, einzusparen. Ein gängiger Energieverbrauchswert liegt bei um die 5 Watt pro integriertes Energieaufnahmeelement, welches zur Weiterleitung auch noch ein PowerLine Modem umfasst welches ebenfalls mit Strom zu versorgen ist.
Verbrauchswerte von kleiner 1 Watt, bzw. kleiner 0,3 Watt bzw. kleiner 0,1 Watt werden durch die Kombination der folgenden schaltungstechnischen Maßnahmen erreicht:
Die Verwenden eines kapazitiven Vorwiderstandes bringt eine erste Leistungsreduktion mit sich.

Die Verwendung reiner Hardwarelösungen bringt mit sich, dass keine Softwarelösung verwendet wird, wodurch vorteilhaft nur die Hardwareanteile in Betrieb gesetzt werden, welche gerade von Nöten sind. Bei Softwarelösungen muß hingegen eine gewisse Hardwarcresource dauernd in Betrieb gehalten werden, um die Software zu betreiben.

Das Abschalten nicht benötigter Baugruppen bewirkt ebenfalls, dass lediglich die eine Hardwarekomponenten mit Leistung zu versorgen sind, die gerade situativ benötigt werden. Dies kann einerseits durch ein zyklisches Aufwecken der benötigten Baugruppe aus dem Ruhezustand bewirkt werden, indem die in Frage kommenden Baugruppen nicht dauernd, sondern nur in festzulegenden Intervallen angesprochen werden. Es kann aber ergänzend oder alternativ auch durch ein anforderungsbedingtes Aufwecken der benötigten Baugruppe aus dem Ruhezustand bewirkt werden. Eine weitere Maßnahme zur Reduktion von Verbrauchsleistung ist die Aufnahme von Energie in Momenten niedriger Netzspannung. Durch die Kombination dieser Maßnahmen liegen gängige momentane Verbrauchswerte bei 0,09Watt.

Eine vorteilhafte Ausgestaltungsform der Erfindung, bei welcher die Schaltung von Lampen bei einem Leistungsverbrauch der Analysevorrichtung von 0,1 Watt möglich ist bewirkt, dass trotz einer derart geringen Standby-Leistung es der Einheit noch immer möglich ist, den zugehörigen Verbraucher mit Informationen und/oder Befehlen zu versorgen, den Verbraucher also beispielsweise ein- bzw. auszuschalten, obwohl die ihm vorgeschaltene Einheit mit minimaler Stand-By-Leistung von kleiner 1 Watt, bzw. kleiner 0,3 Watt bzw. kleiner 0,1 Watt betrieben wird.

Eine vorteilhafte Ausgestaltungsform der Erfindung, bei welcher der an ein Hausstromnetz angeschlossene Stromverbraucher ein zumindest teilweise elektrisch betriebenes Kraftfahrzeug ist, welches als Stromverbraucher die Einheit umfasst und wobei die Empfangsstelle geeignet ist sowohl dem Kraftfahrzeug zugeführten Strom und/oder Leistung, als auch von diesem empfangenen Strom und/oder Leistung zu verarbeiten und/oder mit Hilfe vorgegebener Algorithmen zu verrechnen, bewirkt, dass die erfindungsgemäße Analysevorrichtung auch als Haus-KFZ-Stromtankstelle geeignet ist. So kann ein KFZ, worunter auch Motorräder fallen, welches von der Analysevorrichtung als Verbraucher angesehen wird, mit Strom "aufgetankt" werden und es kann jeweils eine eigene "Tankrechnung" durch die Analysevorrichtung erstellt werden. Dies ist von besonderem Vorteil, da die künftig zu erwartenden elektrisch betriebenen KFZ noch eine recht geringe Reichweite aufweisen und es mit der erfindungsgemäßen Lösung möglich ist, dass jeder Fahrer sein KFZ an jeder Anschlußmögliehkeit "auftankt", beispielsweise im Fall, dass Kraftfahrzeugstellplätze, wie beispielsweise Supermarktparkplätze über derartige "Auftankmöglichkeiten" verfügen werden, während des Einkaufs im Supermarkt, des Besuchs eines Restaurants, Kinos, Theaters, während der Reparatur eines KFZ in einem Autohaus etc, Entsprechendes gilt für Tankstellen, welche neben ihren gängigen Zapfsäulen es KFZ auch erlauben, Strom zu tanken. Entsprechendes gilt weiterhin für sonstige Fahrzeuge, wie Schiffe.

Eine vorteilhafte Ausgestaltungsform der Erfindung, bei welcher für die dem Kraftfahrzeug zur Verfügung gestellte Leistung und/oder vom Kraftfahrzeug empfangene Leistung eine eigene Abrechnung erfolgt. Bewirkt, dass eine sofortige Abrechnung, beispielsweise an der Kasse des Supermarkts, Restaurants, Kinos, Theaters möglich ist.

### Es zeigen

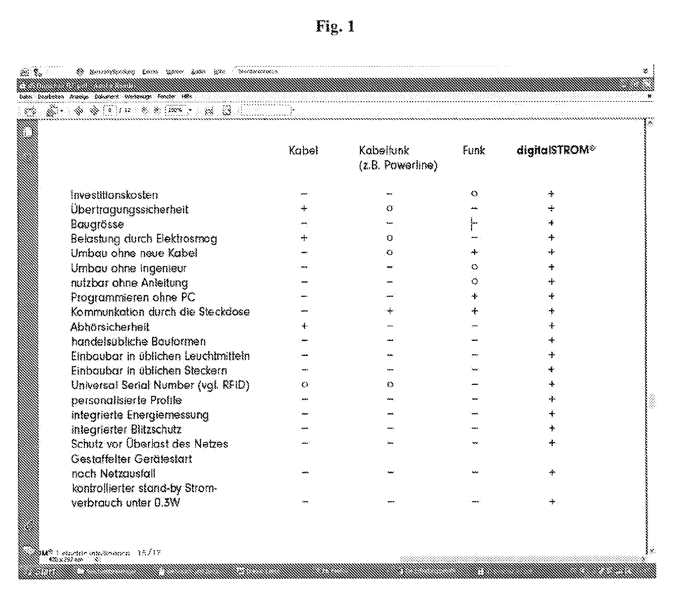

Fig. 1 eine Tabelle an Vorteilen des zugrundeliegenden digitalSTROM-Konzepts gegenüber anderen gängigen Konzepten.

Fig. 2 einen auf dem Markt befindlichen "Smart Meter".

DigitalSTROM arbeitet nicht mit einem Übertragungsverfahren, wie man es von Powerline her kennt. Die Information wird beispielsweise mit Hilfe der in der WO 05124477 geschildert Weise übertragen. Bisher unerreicht hohe Übertragungssicherheit und extrem kompakte Bauformen durch MOSFET Technik sind dadurch möglich.

Hierdurch weist digitalSTROM eine Zuverlässigkeit auf, die größer ist, als Funklösungen oder Powerline Systeme.

Die Einbaubarkeit in einen elektrischen Verbraucher kann sichergestellt werden, indem Prozessor, Speicher, Netzteil und Kommunikationsmodul von digitalSTROM auf einem einzigen Hochvoltchip integriert werden (dSID-Chip). DigitalSTROM kann daher in jeden, insbesondere jeden an das Stromnetz anschließbaren elektrischen Verbraucher eingebaut werden, ohne dass z.B. Gehäuse in großem Maße umgebaut werden müssten. Dieser digtialSTROM Chip realisiert darüber hinaus einen integrierten Überlastschutz des Stromnetzes, einen effektiven Blitzschutz und eine Abschaltautomatik für defekte Geräte.

DigitalSTROM kann wegen seines Ansatzes auch zusammen mit anderen Bussystemen auf einer Stromleitung betrieben werden. Powerline und Powerplug werden durch digitalSTROM nicht beeinträchtigt. digitalSTROM bleibt unbeeinflusst von Powerline oder Powerplug.

Das der Erfindung zu Grunde liegende Konzept des digitalSTROM ist ein so genanntes Strom-Bussystem für eine jede Wohnung. Die Elektrische Geräte mit der digitalSTROMready-Eigenschaft (dS-ready), also der Fähigkeit ausgestattet ist, individuell Verbrauchsdaten eines jeden Verbrauchers in einer Einheit auf die erfindungsgemäße Weise zu ermitteln. Derartige Verbraucher vernetzen sich dann untereinander in der Wohnung über die bereits existierende Stromleitung. Dadurch arbeiten diese Geräte nicht, wie bisher, jedes für sich, sondern automatisch zusammen. Hierdurch erfolgen ohne Mehrkosten:
- eine bessere Kontrolle über den Energieverbrauch Ihrer Geräte
- mehr Komfort bei der Bedienung
- mehr Sicherheit

Typische Anwendungen für digital STROM sind:
- DigitalSTROM ist prinzipiell in jedem Lebensbereich einsetzbar wo Strom verbraucht wird.
- Die Technologie kann grundsätzlich in jedem elektrischen Gerät eingesetzt werden.

Dadurch sind sehr viele Anwendungen möglich. Insbesondere fallen hierunter:
- Beleuchtungssteuerungen mit Dimmen und Szenenschaltungen
- Dimmen und Schalten von Stehleuchten von der Türe aus
- Alles-Aus Funktion beim Verlassen der Wohnung (Zentralverriegelung)
- eine Ampel als Energieverbrauchsanzeige für die Steckdose
- Motorsteuerungen für Jalousien, Markisen

Hieraus ergeben sich die Vorteile:
- Energie wird gespart, weil der individuelle Energieverbrauch erstmals überwacht wird.
- Der Komfort wird erhöht (z.B. individuelle Beleuchtungsszenen werden möglich, Urlaubssimulationen, Zentral-aus-Funktionen, wie z.B. bei einem Alarm-Knopf, etc.).
- Die Sicherheit wird erhöht (effektiver Überspannungsschutz, Abschaltung defekter elektrischer Geräte ist möglich, Zentral-aus, etc.),
- Weniger Kabel sind nötig und müssen bei neuen Funktionen nur in Ausnahmen verlegt werden.
- Neue Geräte werden einfach in die Steckdose gesteckt, und schon funktionieren sie im digitalSTROM-Verbund.
- Für die Programmierung ist keinen Ingenieur oder Elektriker notwendig, sondern diese ist durch den Bediener möglich. Alle wichtigen Funktionen sind werkseitig so grundeinstellbar, dass sie nach dem Einschalten sofort funktionieren.
- Altgeräte können im Bestand bleiben und auf digitalSTROM-fähige Geräte kann Schritt für Schritt umgestellt werden.
- Die Anzahl der Schalter und Fernbedienungen im Haus sinkt, obwohl der Komfort steigt.
- Es ist nicht mehr nötig für jedes Gerät eine Bedienungsanleitung zu lesen.

Beim Umstieg auf digitalSTROM ist es anders als bei jedem anderen Bussystem, nicht notwendig, sich für einen System-Standard zu entscheiden. Wenn einem Bediener die Funktionen dieser digitalSTROM-fähigen Geräte gefallen, kann er sie einfach in die Steckdose stecken und schon von deren Eigenschaften und Vorteilen profitieren. Wenn diese Geräte dann auch noch untereinander zusammenarbeiten sollen (z.B. Szenenschaltungen oder Zentral-aus bei Licht), dann kann eine autorisierte Person im Sicherungskasten einen digitalSTROM-Sensor für den entsprechenden Stromkreis installieren. Ab dann kommunizieren diese Geräte auch untereinander. Dies ist ein zusätzliches Merkmal, welches zusätzlich zur Fähigkeit gegeben ist, Verbrauchsdaten individuell zu ermitteln.

Eine weitere Eigenschaft von digitalSTROM ist dessen Umweltfreundlichkeit. Digitalstrom verbessert die Umweltverträglichkeit in folgenden Punkten:
Energiemenge: Bisher wird der Strom einfach nur in die Gebäude gedrückt. Niemand hatte bisher eine Chance, zu "sehen" wo und wie er verbraucht wird. Mit digitalSTROM weiß man, wie viel Strom wo und wofür gebraucht wird. Damit besteht erstmals überhaupt die Möglichkeit, Verschwendung zu vermeiden.
Lastmanagement: Zu wissen, wie viel Strom wo und wofür gebraucht wird und zugleich steuernd eingreifen zu können, ist die Grundlage für ein aufgrund der Erfindung neuartiges Lastmanagement, das die Vorhaltekosten der Energieversorger reduziert.
Ressourcen: Glühlampen oder Energiesparlampen haben z.B. mit digitalSTROM eine viel längere Lebenszeit. Der drohende Defekt elektrischer Geräte kann gemessen werden und eine rechtzeitige Wartung oder Reparatur eine Neuanschaffung vermeiden helfen.
Mit digitalSTROM kann konkret auf mehreren Wegen Energie gespart werden:
   DigitalSTROM Geräte haben einen Stand-by-Verbrauch von unter 0.3 W (zum Vergleich: ein Ladegerät für ein Mobiltelefon braucht, ohne dass ein Telefon angeschlossen, ist 3-5 W).
   Der digitalSTROM Stromsensor misst den Stromverbrauch sehr genau und kann den Verbrauch für jedes angeschlossene digitalSTROM Gerät aufschlüsseln. Man weiß also z.B., wie viel Strom der Fernseher in der letzten Woche gebraucht hat.
   Der digitalSTROM Stromsensor meldet sich, wenn ein digitalSTROM Gerät einen unüblich hohen Stromverbrauch hat (z.B. weil der Kühlschrank nicht ganz geschlossen ist, oder seine Isolierung feucht geworden ist).
   Beim Verlassen der Wohnung können alle elektrischen Verbraucher wie Lampen, Kaffeemaschine, Bügeleisen, etc. auf Knopfdruck ausgeschalten werden.
   Manche Verbraucher, wie z.B. ein Kellerliclit brennen oft tage- und wochenlang. digitalSTROM schaltet solche Verbraucher spätestens nach ein paar Stunden stufenweise ab.
   Der digitalSTROM kann den aktuellen Stromverbrauch z.B. durch eine kleines Ampellicht für die Steckdose darstellen, so dass der aktuelle Verbrauch im Blick bleibt.
   Darüber hinaus ist der Computer oder das Mobiltelephon mit digitalSTROM verbindbar:
      Man kann hiefür im Sicherungskasten einen digitalSTROM-(dS)-Webserver installieren. Damit hat man dann vollen Zugriff auf die Systemfunktionalität über die offenen Standards des Internets. Weiterhin kann mit Hilfe eines eigenen dS-ready-Computers (z.B. Smartphones, Laptops etc.), dieser über sein Netzteil und die Stromleitung mit der eigenen Wohnung kommunizieren kann.

DigitalSTROM-Systeme sind darüber hinaus preiswert:

Bisherige Bussysteme sind sehr kostenintensiv. Eine digitalSTROM Installation ist nicht teurer, als eine herkömmliche Installation, da Zusatzleitungen wegfallen und die Anzahl der Schalter reduziert werden kann. Mit digitalSTROM wird so das Luxusprodukt "smart home" für einen breiten Markt zugänglich gemacht werden und damit seine Möglichkeiten der Energieeinsparung

Weiterhin funktionieren Produkte mit der Kennzeichnung dS-ready auch in einer jeden herkömmlichen Installation, was Umbaukosten vermeidet. dS-ready-Produkte sind also ohne weiteres einsetzbar und die dS Funktionen einer Lampe wie Softstarter, Dimmer, oder Presets nutzen dem Kunden bei jedem Einzelgerät. Wenn gewünscht wird, dass die dS-ready-Produkte eines Raumes zusammenarbeiten und Lichtszenen aus mehreren Lampen oder eine Bedienung vom Lichtschalter in der Wand gewünscht wird, kann im Sicherungskasten eine Vorrichtung hierfür installiert werden.

Einem Energieversorger bietet digitalSTROM den Vorteil erstmals über eine Palette von neuen Funktionen zu verfügen, mit denen Stromverschwendung vermieden werden kann:
- Eine differenzierte Verbrauchsmessung pro Stromkreis und pro elektrischem Gerät ohne Mehrkosten
- Ein kontrollierter Standby Betrieb unter 0.3 W von jedem elektrischen Gerät
- Eine Überwachung defekter elektrischer Geräte (pre-maintenance)
- Remote Zugriff auf einzelne elektrische Geräte
- Nutzerfeedback

Möglich sind dadurch:
- differenziertes Lastmanagement
- Vermeidung von Lastspitzen und günstiger Einkauf
- neue, differenzierte Tarif systeme mit Nutzerfeedback
- neue Produkte und Dienstleitungen rund ums Energiesparen
- neue Marketingstrategien
digitalSTROM wurde außerdem entworfen, um die Infrastruktur der Stromversorgung nach Möglichkeit zu entlasten:
- digitalSTROM bietet die technische Grundlage für ein differenziertes Lastmanagement mit Nutzerfeedback, sowie neuartige Tarif systeme.
- digitalSTROM hilft Lastspitzen zu vermeiden.
- digitalSTROM entlastet die Netze durch einen kontrollierten Standby elektrischer Geräte, sowie die Überwachung defekter Geräte.
- digitalSTROM Geräte können die Über- oder Unterlast des Stromnetzes erkennen und gegebenenfalls selbstständig abschalten, um dem Zusammenbruch des Netzes vorzubeugen, Dies geschieht ohne Investitionen in eine zentrale Infrastruktur und ist daher eine ausgesprochen preiswerte Lösung zur Stabilisierung der Netzwerke.
- Nach einem Netzausfall starten digitalSTROM Geräte in kontrollierter Reihenfolge und vereinfachen dadurch das komplizierte Aufschalten eines Teilnetzes erheblich.

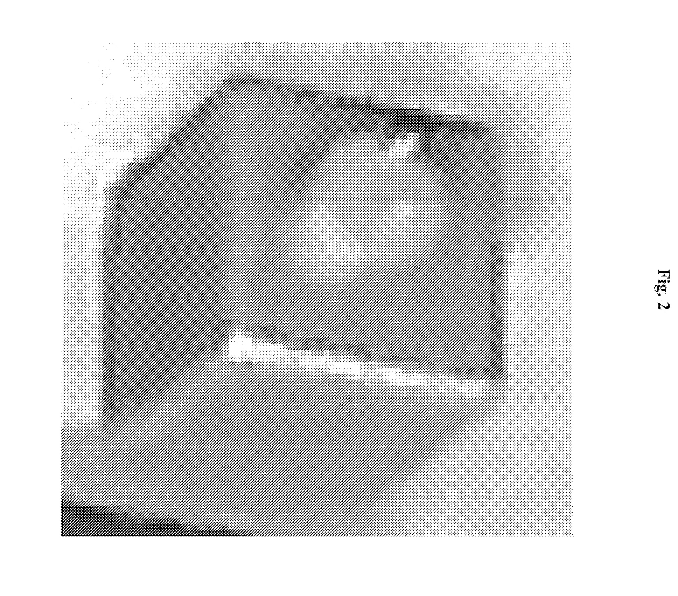

Der in Fig. 2 dargestellte auf dem Markt befindliche "Smart Meter" lässt erkennen, dass er die genormte Größe eines Schuko-Steckers überragt.

## Patentansprüche

1. Analysevorrichtung für Stromverbraucher umfassend: mindestens einen an ein Hausstromnetz angeschlossenen Stromverbraucher, wobei der Stromverbraucher eine Einheit umfasst, die geeignet ist den Stromverbrauch und/oder Leistungsverbrauch genau dieses einen Verbrauchers zu identifizieren und als Information bereitzustellen, mindestens eine Empfangsstelle für diese, durch mindestens einen Stromverbraucher bereitgestellten Informationen, wobei diese Empfangsstelle geeignet ist, bei Zuschalten und/oder Ausschalten eines jeden Einzelnen dieser Stromverbraucher Informationen aus einem jeden Einzelnen dieser Stromverbraucher getrennt aufzunehmen und/oder getrennt zu verarbeiten und/oder mit Hilfe vorgegebener Algorithmen zu verrechnen

2. Analysevorrichtung für Stromverbraucher nach einem der zuvor genannten Ansprüche, wobei die Empfangsstelle erkennt, welcher Verbraucher an der Stromversorgung angeschlossen ist.

3. Analysevorrichtung für Stromverbraucher nach einem der zuvor genannten Ansprüche, wobei die Empfangsstelle einen jeden Verbraucher wiedererkennt, wenn er von seiner bisherigen Stromversorgung abgekoppelt und an einer anderen Stelle erneut an die Stromversorgung angekoppelt wird.

4. Analysevorrichtung für Stromverbraucher nach Anspruch 3, wobei beim Ein- und/oder auskoppeln ein jeder Verbraucher einem Verbrauchskonto zugeordnet wird.

5. Analysevorrichtung nach Anspruch 2 bis 4, wobei die Empfangsstelle erkennt, welches Gerät an der Stromversorgung angeschlossen ist, indem die Einheit geeignet ist den Stromverbrauch und/oder Leistungsverbrauch genau dieses betreffenden Verbrauchers zu identifizieren und als Information bereitzustellen, indem diese Einheit gerätetypische Informationen bereitstellt.

6. Analysevorrichtung nach Anspruch 5, wobei diese gerätetypischen Informationen die Gestalt einer Geräteidentifikationsziffer, und/oder die Gestalt eines gerätetypischen Schwingungsverhalten im Versorgungsstrom und/oder in der Versorgungsspannung, und/oder die Gestalt gerätetypischer Zusatzinformationen aufweisen.

7. Analysevorrichtung nach Anspruch 6, wobei die Geräteidentifikationsziffer, einen Code für das Herkunftsland und/oder die Gerätegruppe und/oder den Gerätetyp und/oder eine Leistungsgruppe und/oder eine Energieeffizienzgruppe umfaßt.

8. Analysevorrichtung nach Anspruch 6, wobei die gerätetypischen Zusatzinformationen für das Gerät charakteristische Sensordaten, die beispielsweise Temperaturinformationen, feuchtigkeitsinformationen, Füllstände, Hclligkeitsinformationen, Lautstärkeinformationen, Steuerungsinformationen, Verlaufsinformationen eines durchgeführten Arbeitsprozesses, Informationen betreffend des Verbrauchs von Verbrauchsmaterialien umfassen.

9. Analysevorrichtung nach einem der vorhergehenden Ansprüche, wobei die gerätetypischen Informationen über die Stromleitung zu einer von der Einheit örtlich getrennten Empfangsstelle weitergeleitet werden.

10. Analysevorrichtung für Stromverbraucher nach einem der vorhergehenden Ansprüche, wobei die Informationsübertragung zwischen einem jeden Verbraucher und der Analysevorrichtung über das bestehende Stromnetz erfolgt oder indem die gerätetypischen Informationen in der Energieversorgungsleitung mit Hilfe des elektrischen Stroms als Trägermedium zur Empfangsstelle weitergeleitet werden.

11. Analysevorrichtung für Stromverbraucher nach einem der zuvor genannten Ansprüche, wobei die Informationsübertragung mit Hilfe der Stromversorgungsleitung mit mehr als 50Hertz, i.e. mehr als 50 Bit/Sec erfolgt.

12. Analysevorrichtung für Stromverbraucher nach Anspruch 11 wobei die Informationsübertragung mit Hilfe der Stromversorgungsleitung mit mehr als 100Hertz, i.e. mehr als 100 Bit/Sec erfolgt.

13. Analysevorrichtung für Stromverbraucher nach einem der zuvor genannten Anspruche, wobei der Beginn der Informationsübertragung ausschließlich durch einen Wirkleistungsimpuls bereitgestellt wird.

14. Analysevorrichtung für Stromverbraucher nach einem der zuvor genannten Ansprüche, wobei die Analysevorrichtung jeden individuellen und/oder berechneten Stromverbrauch auszugeben in der Lage ist.

15. Analysevorrichtung für Stromverbraucher nach einem der zuvor genannten Ansprüche, wobei die Analysevorrichtung die Kosten ermittelt, welche dem aktuellen Energieverbrauch eines jeden dieser Stromverbrauchers entsprechen.

16. Analysevorrichtung für Stromverbraucher nach einem der zuvor genannten Ansprüche, wobei die Analysevorrichtung jeden individuellen und/oder berechneten Stromverbrauch einer Gerätegruppe auszugeben in der Lage ist.

17. Analysevorrichtung für Stromverbraucher nach Anspruch 16, die geeignet ist, genau diesem Stromverbraucher die Energiezufuhr zu reduzieren, oder ihn an- bzw. auszuschalten.

18. Analysevorrichtung für Stromverbraucher nach einem der zuvor genannten Ansprüche, wobei die Ausgabe von Daten mit Hilfe von Fernkommunikationsmitteln an einem Ort geschieht, der sich außerhalb des Gebäudes befindet, in welchem diese Daten aufgenommen wurden.

19. Analysevorrichtung für Stromverbraucher nach einem der zuvor genannten Ansprüche, wobei die Analysevorrichtung Zugriff auf Informationen hat, die als Maßstab für den Verschleißzustand eines jeden Verbrauchers dienen.

20. Analysevorrichtung für Stromverbraucher nach einem der zuvor genannten Ansprüche, wobei die elektronischen Bauelemente der gesamte Analysevorrichtung kleiner gleich 3 Watt oder kleiner gleich 1 Watt oder kleiner gleich 0,3 Watt oder kleiner gleich 0,1 Watt Leistung verbrauchen.

21. Analysevorrichtung für Stromverbraucher nach Anspruch 20, wobei die Eigenverbranchswerte von kleiner 1 Watt, bzw. kleiner 0,3 Watt bzw. kleiner 0,1 Watt durch das Zusammenwirken der folgenden Einzelmaßnahmen, die die Einheit und/oder die Empfangsstelle betreffen, erreicht werden:
• Verwendung reiner Hardwarelösungen
• Verwenden eines kapazitiven Vorwiderstandes;
• Abschalten nicht benötigter Baugruppen;
• zyklisches Aufwecken der benötigten Baugruppe aus dem Ruhezustand;
• anforderungsbedingtes Aufwecken der benötigten Baugruppe aus dem Ruhezustand;
• Aufnahme von Energie in Momenten niedriger Netzspannung;

22. Analysevorrichtung für Stromverbraucher nach Anspruch 21, wobei die Schaltung von Lampen bei einem Leistungsverbrauch der Analysevorrichtung von 0,1 Watt möglich ist.

23. Analysevorrichtung für Stromverbraucher nach einem der vorhergehenden Ansprüche, wobei der an ein Hausstromnetz angeschlossene Stromverbraucher ein zumindest teilweise elektrisch betriebenes Kraftfahrzeug ist, welches als Stromverbraucher die Einheit umfasst und wobei die Empfangsstelle geeignet ist sowohl dem Kraftfahrzeug zugerührten Strom und/oder Leistung, als auch von diesem empfangenen Strom und/oder Leistung zu verarbeiten und/oder mit Hilfe vorgegebener Algorithmen zu verrechnen

24. Analysevorrichtung für Stromoverbraucher nach Anspruch 23, wobei für die dem Kraftfahrzeug zur Verfügung gestellte Leistung und/oder vom Kraftfahrzeug empfangene Leistung eine eigene Abrechnung erfolgt.

25. Kraftfahrzeugstellplatz, umfassend eine Analysevorrichtung nach einem der Ansprüche nach einem der Ansprüche 23, 24.

26. Tankstelle, umfassend eine Analysevorrichtung nach einem der Ansprüche nach einem der Ansprüche 23, 24.
